# EUROPEAN PATENT APPLICATION

(11) **EP 4 531 226 A1**
(43) Date of publication of application: **02.04.2025**
(21) Application number: 23878970.5
(22) Date of filing: 08.10.2023
(51) Int. Cl.: H02J 3/32, H02J 7/00

(54) **ENERGY STORAGE CONTROL SYSTEM**

(30) Priority: 17.10.2022 CN 202222722587 U
(71) Applicant: Contemporary Amperex Future Energy Research Institute (Shanghai) Limited, Shanghai 200241 (CN)
(72) Inventor: LIANG, Pengfei, Shanghai 200241 (CN); LU, Yanhua, Shanghai 200241 (CN); LUO, Bingtuan, Shanghai 200241 (CN); SU, Tan, Shanghai 200241 (CN); FAN, Dashuai, Shanghai 200241 (CN)
(74) Representative: Gong, Jinping
(86) International application number: PCT/CN2023/123408
(87) International publication number: WO 2024/082978

(57) **Abstract**

This application relates to an energy storage control system. The energy storage control system includes a plurality of energy storage modules and a plurality of control apparatuses in one-to-one correspondence with the plurality of energy storage modules, where each control apparatus is connected to the corresponding energy storage module, and the energy storage module includes a battery unit and a power unit, the battery unit including at least one battery group. The control apparatus includes a sub-module controller and at least one battery management system in one-to-one correspondence with the at least one battery group, where each battery management system is connected to the corresponding battery group and the sub-module controller, and the sub-module controller is connected to the power unit. The energy storage control system can be used to control MMC-BESS.

## Description

### RELATED APPLICATIONS

This application claims priority to Chinese Patent Application No. 202222722587X, filed on October 17, 2022 and entitled "ENERGY STORAGE CONTROL SYSTEM", which is incorporated herein by reference in its entirety.

### TECHNICAL FIELD

This application relates to the field of power technologies, and in particular, to an energy storage control system.

### BACKGROUND

In MMC-BESS (Modular Multilevel Converter based Battery Energy Storage System, modular multilevel converter based battery energy storage system) energy storage valves, energy storage batteries are integrated with converters, better meeting the technical development requirements of the future power grid for high power, large capacity, high efficiency, and high dynamics in battery energy storage. Currently, the MMC-BESS energy storage valves include VSC (Voltage Source Converter, voltage source converter) energy storage valves and direct-current direct-connected energy storage valves.

As compared with flexible direct-current converter valve sub-modules, each energy storage module in an MMC-BESS energy storage valve is added with a battery group part. Therefore, control and protection functions based on the battery group need to be added to an MMC-BESS control system. However, there is currently no control system applicable to MMC-BESS.

Therefore, proposing a new control system applicable to MMC-BESS is an urgent problem to be solved by persons skilled in the art.

### SUMMARY

In view of this, it is necessary to address the above technical problems by providing an energy storage control system applicable to an MMC-BESS energy storage valve, an apparatus, a computer device, a computer-readable storage medium, and a computer program product.

According to a first aspect, this application provides an energy storage control system. The energy storage control system includes a plurality of energy storage modules and a plurality of control apparatuses in one-to-one correspondence with the plurality of energy storage modules, where each control apparatus is connected to the corresponding energy storage module, and the energy storage module includes a battery unit and a power unit, the battery unit including at least one battery group; and
the control apparatus includes a sub-module controller and at least one battery management system in one-to-one correspondence with the at least one battery group, where each battery management system is connected to the corresponding battery group and the sub-module controller, and the sub-module controller is connected to the power unit.

In the above energy storage control system, since each battery management system is connected to the corresponding battery group, the battery management system can receive parameter information of the corresponding battery group, such as voltage, temperature, and SOC of the battery group. Further, since each battery management system is connected to the corresponding battery group and the sub-module controller, the battery management system can send the obtained battery group parameter information to the sub-module controller, and the sub-module controller can determine a control strategy for the power unit in the energy storage module based on the battery group parameter information and control the power unit connected thereto based on the control strategy, thereby controlling the MMC-BESS energy storage valve with the battery group added. In conclusion, the energy storage control system provided in this application is an energy storage control system applicable to MMC-BESS.

In an embodiment, the control apparatus further includes a battery management controller, and the sub-module controller is connected to a plurality of battery management systems through the battery management controller.

The above control apparatus avoids the need for the sub-module controller to directly establish communication with a large number of battery management systems, reducing the data throughput of the sub-module controller and improving the control efficiency.

In an embodiment, the energy storage control system further includes a valve base controller, and the valve base controller is connected to the sub-module controller.

In the above embodiment, since the sub-module controller can send the battery group parameter information to the valve base controller after receiving the battery group parameter information, and the valve base controller determines the corresponding control strategy, the processing capacity and processing efficiency of the sub-module controller are reduced.

In an embodiment, the sub-module controller includes a main control chip, and the main control chip is connected to a plurality of battery management systems and the valve base controller.

In the above embodiment, the main control chip in the sub-module controller receives the battery group parameter information from the battery management system, sends the processed battery group parameter information to the valve base controller, and receives the control strategy from the valve base controller, thereby improving the functional integration of the sub-module controller.

In an embodiment, the sub-module controller further includes a power unit trigger circuit, and the power unit trigger circuit is connected to both the main control chip and the power unit.

In the above embodiment, since the sub-module controller further includes a power unit trigger circuit, and the power unit trigger circuit is connected to both the main control chip and the power unit, the sub-module controller can control the power unit based on the control strategy after receiving the control strategy sent by the valve base controller.

In an embodiment, the power unit trigger circuit includes at least one of a transistor trigger circuit, a thyristor trigger circuit, and a bypass switch trigger circuit, where
the transistor trigger circuit is connected to both the main control chip and a transistor in the power unit, the thyristor trigger circuit is connected to both the main control chip and a thyristor in the power unit, and the bypass switch trigger circuit is connected to both the main control chip and a bypass switch in the power unit.

In this embodiment, the power unit trigger circuit includes at least one of the transistor trigger circuit, the thyristor trigger circuit, and the bypass switch trigger circuit, where the transistor trigger circuit is connected to both the main control chip and the transistor in the power unit, the thyristor trigger circuit is connected to both the main control chip and the thyristor in the power unit, and the bypass switch trigger circuit is connected to both the main control chip and the bypass switch in the power unit. Therefore, after receiving the control strategy from the valve base controller, the sub-module controller can control different components in the power unit based on different control strategies to control and protect the energy storage valve.

In an embodiment, the sub-module controller further includes a power unit monitoring circuit, and the power unit monitoring circuit is connected to both the main control chip and the power unit.

In this embodiment, the sub-module controller further includes the power unit monitoring circuit, and the power unit monitoring circuit is connected to both the main control chip and the power unit. Therefore, the sub-module controller can also monitor the power unit to improve the control accuracy of the energy storage valve.

In an embodiment, the power unit monitoring circuit includes at least one of a capacitor voltage monitoring circuit, a bypass switch monitoring circuit, and a transistor monitoring circuit, where
the capacitor voltage monitoring circuit is connected to both the main control chip and a capacitor in the power unit, the bypass switch monitoring circuit is connected to both the main control chip and the bypass switch in the power unit, and the transistor monitoring circuit is connected to both the main control chip and the transistor in the power unit.

In this embodiment, the power unit monitoring circuit includes at least one of the capacitor voltage monitoring circuit, the bypass switch monitoring circuit, and the transistor monitoring circuit, where the capacitor voltage monitoring circuit is connected to both the main control chip and the capacitor in the power unit, the bypass switch monitoring circuit is connected to both the main control chip and the bypass switch in the power unit, and the transistor monitoring circuit is connected to both the main control chip and the transistor in the power unit. Therefore, the sub-module controller can also monitor a state of the component in the power unit to more accurately control the energy storage valve based on the state of the component in the power unit.

In an embodiment, the capacitor voltage monitoring circuit includes a first-stage capacitor voltage monitoring circuit, the first-stage capacitor voltage monitoring circuit including a high-resistance voltage divider circuit, a signal conditioning circuit, and an analog-to-digital conversion circuit, where the analog-to-digital conversion circuit is connected to the high-resistance voltage divider circuit through the signal conditioning circuit, the analog-to-digital conversion circuit is connected to the main control chip, and the high-resistance voltage divider circuit is connected to the capacitor in the power unit.

In this embodiment, the capacitor voltage monitoring circuit includes the first-stage capacitor voltage monitoring circuit, the first-stage capacitor voltage monitoring circuit including the high-resistance voltage divider circuit, the signal conditioning circuit, and the analog-to-digital conversion circuit, where the analog-to-digital conversion circuit is connected to the high-resistance voltage divider circuit through the signal conditioning circuit, the analog-to-digital conversion circuit is connected to the main control chip, and the high-resistance voltage divider circuit is connected to the capacitor in the power unit. Therefore, the sub-module controller can safely and quickly obtain the voltage of the capacitor in the power unit to monitor the voltage of the capacitor in the power unit.

In an embodiment, the capacitor voltage monitoring circuit further includes a second-stage capacitor voltage monitoring circuit, the second-stage capacitor voltage monitoring circuit including a two-stage voltage comparator, where an input terminal of the two-stage voltage comparator is connected to the first-stage capacitor voltage monitoring circuit, and an output terminal of the two-stage voltage comparator is connected to both the main control chip and the bypass switch trigger circuit.

In this embodiment, the capacitor voltage monitoring circuit further includes the second-stage capacitor voltage monitoring circuit, the second-stage capacitor voltage monitoring circuit including the two-stage voltage comparator, where the input terminal of the two-stage voltage comparator is connected to the first-stage capacitor voltage monitoring circuit, and the output terminal of the two-stage voltage comparator is connected to both the main control chip and the bypass switch trigger circuit. Therefore, the second-stage capacitor voltage monitoring circuit can also directly trigger the bypass switch to be turned on based on the voltage of the capacitor in the power unit, improving the safety of the energy storage valve.

In an embodiment, the sub-module controller further includes an energy extraction power supply interface, the energy extraction power supply interface is connected to both a voltage regulator and the main control chip, and the energy extraction power supply interface is connected to an energy extraction power supply.

In this embodiment, the sub-module controller further includes the energy extraction power supply interface, the energy extraction power supply interface is connected to both the voltage regulator and the main control chip, and the energy extraction power supply interface is connected to the energy extraction power supply. Due to the use of the energy extraction power supply after voltage regulation for the main control chip, the operating stability of the sub-module controller is improved.

In an embodiment, the sub-module controller further includes a power supply voltage monitoring circuit, and the power supply voltage monitoring circuit is connected to both the energy extraction power supply interface and the main control chip.

In this embodiment, the sub-module controller further includes the energy extraction power supply interface, the energy extraction power supply interface is connected to both the voltage regulator and the main control chip, and the energy extraction power supply interface is connected to the energy extraction power supply. Therefore, the sub-module controller can also monitor the voltage of the energy extraction power supply to avoid the abnormal situation of insufficient power supply of the energy extraction power supply in the sub-module controller, improving the stability of the sub-module controller in use.

In an embodiment, the sub-module controller further includes an auxiliary power supply interface, and the auxiliary power supply interface is connected to the bypass switch trigger circuit.

In this embodiment, the sub-module controller further includes the auxiliary power supply interface, and the auxiliary power supply interface is connected to the bypass switch trigger circuit. Therefore, the operating stability of the bypass switch is improved.

In an embodiment, the sub-module controller further includes a redundancy interface, and adjacent sub-module controllers in the plurality of control apparatuses and/or the valve base controller is connected to the main control chip through the redundancy interface.

In this embodiment, the sub-module controller further includes the redundancy interface, and the adjacent sub-module controllers in the plurality of control apparatuses or the valve base controller is connected to the main control chip through the redundancy interface. Therefore, the stability of the sub-module controller is improved.

In an embodiment, the control apparatus further includes a fire controller, the fire controller is connected to both a fire sensor corresponding to the battery unit and the sub-module controller, and the fire sensor includes at least one of an electrolyte leakage sensor, a temperature sensor, a gas sensor, and a smoke sensor.

In this embodiment, the control apparatus further includes the fire controller, the fire controller is connected to both the fire sensor corresponding to the battery unit and the sub-module controller, and the fire sensor includes at least one of the electrolyte leakage sensor, the temperature sensor, the gas sensor, and the smoke sensor. Since a fire linkage function is set based on the battery unit, the safety of the energy storage valve is further improved.

The foregoing description is merely an overview of the technical solution of this application. For a better understanding of the technical means in this application such that they can be implemented according to the content of the specification, and to make the above and other objectives, features, and advantages of this application more obvious and easier to understand, the following describes specific embodiments of this application.

### BRIEF DESCRIPTION OF DRAWINGS

To describe the technical solutions in the embodiments of this application more clearly, the following briefly describes the accompanying drawings required for describing the embodiments of this application. Apparently, the accompanying drawings in the following description show merely some embodiments of this application, and persons of ordinary skill in the art may still derive other drawings from the accompanying drawings without creative efforts.
FIG. 1 is a schematic structural diagram of an energy storage control system;
FIG. 2 is a schematic structural diagram of a direct-current direct-connected energy storage valve;
FIG. 3 is a schematic structural diagram of a VCS energy storage valve;
FIG. 4 shows a half-bridge energy storage module;
FIG. 5 shows a full-bridge energy storage module;
FIG. 6 is a schematic structural diagram of another energy storage control system of this application;
FIG. 7 is a schematic structural diagram of another energy storage control system of this application;
FIG. 8 is a schematic structural diagram of a sub-module controller of this application;
FIG. 9 is a schematic structural diagram of another sub-module controller of this application;
FIG. 10 is a schematic structural diagram of another sub-module controller of this application; and
FIG. 11 is a schematic diagram of another energy storage control system of this application.

Description of reference signs:
100. energy storage control system; 101. energy storage module; 102. power unit; 103. battery unit; 104. control apparatus; 105. battery management system; 106. battery management system; 107. battery management system; 108. sub-module controller; 109. energy storage module; 110. power unit; 111. battery unit; 112. control apparatus; 113. battery management system; 114. battery management system; 115. battery management system; 116. sub-module controller; 401. thyristor; 402. bypass switch; 403. upper IGBT; 404. lower IGBT; 405. anti-parallel diode; 406. anti-parallel diode; 407. equalizing resistor; 408. capacitor; 409. battery unit; 410. power unit; 501. thyristor; 502. bypass switch; 503. upper IGBT; 504. lower IGBT; 505. anti-parallel diode; 506. anti-parallel diode; 507. upper IGBT; 508. lower IGBT; 509. anti-parallel diode; 510. anti-parallel diode; 511. equalizing resistor; 512. capacitor; 513. battery unit; 514. power unit; 600. energy storage control system; 601. battery management controller; 602. battery management controller; 700. energy storage control system; 701. valve base controller; 801. sub-module controller; 802. power supply voltage monitoring circuit; 803. main control chip; 804. power unit monitoring circuit; 805. power unit trigger circuit; 806. power unit; 1100. energy storage control system; 1101. fire controller; and 1102. fire controller.

### DESCRIPTION OF EMBODIMENTS

The following describes in detail the embodiments of the technical solutions of this application with reference to the accompanying drawings. The following embodiments are merely intended for a clearer description of the technical solutions of this application and therefore are used as just examples which do not constitute any limitations on the protection scope of this application.

Serial numbers allocated to components in this specification, such as "first" and "second", are only used to distinguish described objects and indicate no sequence or technical meaning. In addition, "connection" or "linkage" in this application includes a direct and indirect connection (linkage) unless otherwise specified. In the description of this application, it should be understood that the orientations or positional relationships indicated by the terms "upper", "lower", "front", "rear", "left", "right", "vertical", "horizontal", "top", "bottom", "inside", "outside", "clockwise", "counterclockwise", and the like are based on the orientations or positional relationships as shown in the accompanying drawings. These terms are merely for the ease and brevity of description of this application rather than indicating or implying that the means or components mentioned must have specific orientations or must be constructed or manipulated according to specific orientations, and therefore shall not be construed as any limitations on this application.

In this application, unless otherwise clearly specified and defined, a first feature being "on" or "under" a second feature may mean that the first and second features are in direct contact, or the first and second features are in indirect contact through an intermediary. Moreover, that the first feature is "above", "over", or "on" the second feature may mean that the first feature is directly above or obliquely above the second feature or simply mean that the first feature has a higher level than the second feature. That the first feature is "below", "beneath", and "under" the second feature may mean that the first feature is directly below or obliquely below the second feature or simply mean that the first feature has a lower level than the second feature.

To make the objectives, technical solutions, and advantages of this application clearer and more comprehensible, the following further describes this application in detail with reference to the accompanying drawings and embodiments. It should be understood that the specific embodiments described herein are merely intended to explain this application rather than to limit this application.

Currently, an MMC-BESS energy storage valve is a novel energy storage valve. As compared with flexible direct-current converter valve sub-modules, each energy storage module in the MMC-BESS energy storage valve is added with a battery group part. Therefore, control and protection functions based on the battery group need to be added to an MMC-BESS control system. However, there is currently no control system applicable to MMC-BESS.

Based on the above considerations, the applicant, through in-depth research, has proposed an energy storage control system applicable to MMC-BESS. The energy storage control system includes a plurality of energy storage modules and a plurality of control apparatuses in one-to-one correspondence with the plurality of energy storage modules, where each control apparatus is connected to the corresponding energy storage module, and the energy storage module includes a battery unit and a power unit, the battery unit including at least one battery group. The control apparatus includes a sub-module controller and at least one battery management system in one-to-one correspondence with the at least one battery group, where each battery management system is connected to the corresponding battery group and the sub-module controller, and the sub-module controller is connected to the power unit. Since each battery management system is connected to the corresponding battery group, the battery management system can receive parameter information of the corresponding battery group, such as voltage, temperature, and state of charge of the battery group. Further, since each battery management system is connected to the corresponding battery group and the sub-module controller, the battery management system can send the obtained battery group parameter information to the sub-module controller, and the sub-module controller can determine a control strategy for the power unit in the energy storage module based on the battery group parameter information and control the power unit connected thereto based on the control strategy, thereby controlling the MMC-BESS energy storage valve with the battery group added. In conclusion, the energy storage control system provided in this application is an energy storage control system applicable to MMC-BESS.

The following introduces the energy storage control system of this application, where the energy storage control system includes a plurality of energy storage modules, each energy storage module includes a battery unit and a power unit, and the battery unit includes at least one battery group. Each energy storage module corresponds to one control apparatus, where the control apparatus includes a sub-module controller (Sub-Module Controller, SMC) and at least one battery management system (Battery Management System, BMS) in one-to-one correspondence with at least one battery group.

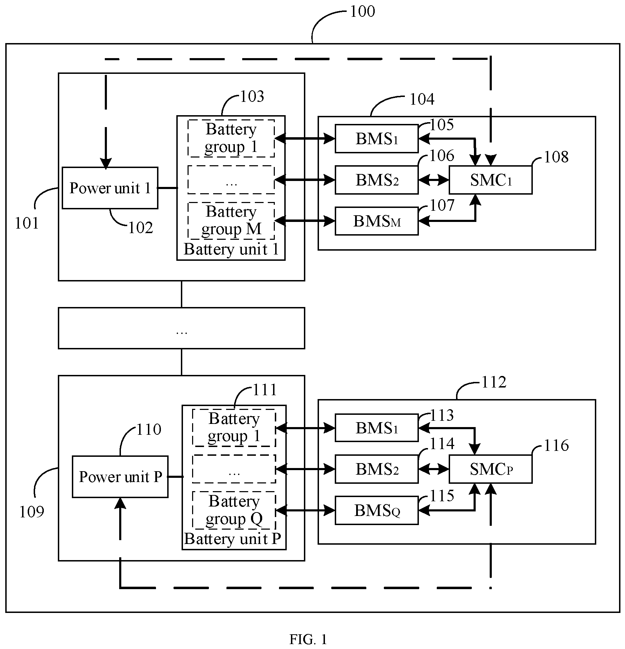

Referring to FIG. 1, FIG. 1 is a schematic structural diagram of an energy storage control system. An energy storage control system 100 including an energy storage module 101 and an energy storage module 109 is used as an example, where the energy storage module 101 includes a power unit 102 and a battery unit 103, and the energy storage module 109 includes a power unit 110 and a battery unit 111. The battery unit 103 includes M battery groups, and the battery unit 111 includes Q battery groups, where M and Q are both integers greater than 0, and M and Q may be equal or unequal.

Further, the energy storage control system 100 further includes a plurality of control apparatuses in one-to-one correspondence with a plurality of energy storage modules, and each control apparatus is connected to the corresponding energy storage module. Still referring to FIG. 1, the energy storage module 101 corresponds to a control apparatus 104, and the energy storage module 101 is connected to the control apparatus 104. The energy storage module 109 corresponds to a control apparatus 112, and the energy storage module 109 is connected to the control apparatus 112.

Furthermore, the control apparatus includes a sub-module controller and at least one battery management system in one-to-one correspondence with the at least one battery group, where each battery management system is connected to the corresponding battery group and the sub-module controller, and the sub-module controller is connected to the power unit. For example, the control system 104 includes a battery management system 105, a battery management system 106, a battery management system 107, and a sub-module controller 108. The battery unit 103 includes battery groups 1 to M, where the battery group 1 is connected to the battery management system 105, and the battery group 2 is connected to the battery management system 106. By analogy, the battery group M is connected to the battery management system 107. In addition, the battery management system 105, the battery management system 105, and the battery management system 107 are all connected to the sub-module controller 108.

Similarly, the control system 112 includes a battery management system 113, a battery management system 114, a battery management system 115, and a sub-module controller 116. The battery unit 111 includes battery groups 1 to Q, where the battery group 1 is connected to the battery management system 113, and the battery group 2 is connected to the battery management system 114. By analogy, the battery group M is connected to the battery management system 115. In addition, the battery management system 113, the battery management system 114, and the battery management system 115 are all connected to the sub-module controller 116.

In other words, the number of energy storage modules in the energy storage control system is equal to the number of control apparatuses, where one energy storage module corresponds to one control apparatus. The number of battery groups in the battery unit of each energy storage module is equal to the number of battery management systems in the corresponding control apparatus.

For example, assuming that the energy storage control system 100 includes P energy storage modules, where P is an integer greater than 1, the energy storage control system 100 also includes P power units, P battery units, and P control apparatuses. One control apparatus includes one sub-module controller and battery management systems, where the number of battery management systems is equal to the number of battery groups in the battery unit of the corresponding energy storage module. For example, the control apparatus 104 includes M battery management systems, and the control apparatus 112 includes Q battery management systems.

Further, the sub-module controller is connected to the power unit. Still referring to FIG. 1, the sub-module controller 108 is connected to the power unit 102, and the sub-module controller 116 is connected to the power unit 110.

Referring to FIG. 1, in this embodiment, the battery management system receives the voltage, temperature, SOC, state of health (State Of Health, SOH), state of power (State Of Power, SOP), state of safe (State Of Safe, SOS), state of function (State Of Function, SOF), and state of energy (State Of Energy, SOE) and other battery group parameter information from the corresponding battery group.

M being 3, that is, the control apparatus 104 including three battery management systems is used as an example, where the battery management system 105, the battery management system 106, and the battery management system 107 respectively receive the battery group parameter information sent by the battery group 1, the battery group 2, and the battery group 3, and then the battery management system 105, the battery management system 106, and the battery management system 107 send the obtained battery group parameter information to the sub-module controller 108. The sub-module controller 108 can determine a control strategy of the energy storage module 101 based on the obtained battery group parameter information, and then the sub-module controller 108 controls the corresponding power unit 102 based on the control strategy.

Certainly, the sub-module controller 108 can alternatively forward the obtained battery group parameter information to another upper-level control system, and the another control system returns a control strategy to the sub-module controller 108 based on the battery group parameter information, so that the sub-module controller 108 controls the corresponding power unit 102 based on the control strategy.

The sub-module controller 108 can alternatively process the obtained battery group parameter information and then send the processed battery group parameter information to another upper-level control system, and the another control system returns a control strategy to the sub-module controller 108 based on the processed battery group parameter information, so that the sub-module controller 108 controls the corresponding power unit 102 based on the control strategy.

For example, after receiving the battery group parameter information, the sub-module controller 108 analyzes and confirms that the battery unit in the energy storage module has a serious overvoltage risk, then the sub-module controller 108 can control the bypass switch in the power unit to be turned on, so that the battery unit is shortcircuited from the energy storage valve, reducing the risk and protecting the energy storage valve. The sub-module controller 108 can alternatively send alarm information after analyzing and confirming that the battery unit in the energy storage module has a serious overvoltage risk, so that the bypass switch in the power unit can be manually controlled to be turned on when the sub-module controller 108 sends the alarm information.

In some illustrative embodiments, after controlling the power unit of the corresponding energy storage module based on the control strategy, the sub-module controller can control the branch switching and branch circulating current suppression of the energy storage valve. The branch switching refers to that the number of energy storage modules turned on or off in the energy storage valve is controlled, and the dynamic balance of the number of energy storage modules turned on is maintained. For example, the energy storage valve includes 100 energy storage modules, and the energy storage valve needs to keep 50 energy storage modules operating simultaneously during normal operation, so that the sub-module controller can control energy storage modules 1 to 50 to be turned on and energy storage modules 51 to 100 to be turned off, or control the energy storage modules 1 to 50 to be turned off and the energy storage modules 51 to 100 to be turned on. The branch circulating current suppression refers to that different energy storage modules in the energy storage valve are controlled to be turned on or off to avoid circulating current between operating energy storage modules or between the interiors of energy storage modules. For example, if the voltage of the battery group in an energy storage module 1 differs greatly from the voltage of the capacitor, a circulating current exists in the energy storage module 1, so that the sub-module controller can control the energy storage module 1 to be turned off, and an energy storage module 2 is turned on to operate.

In this embodiment, the energy storage control system includes the plurality of energy storage modules and the plurality of control apparatuses in one-to-one correspondence with the plurality of energy storage modules, where each control apparatus is connected to the corresponding energy storage module, and the energy storage module includes the battery unit and the power unit, the battery unit including at least one battery group. The control apparatus includes the sub-module controller and at least one battery management system in one-to-one correspondence with the at least one battery group, where each battery management system is connected to the corresponding battery group and the sub-module controller, and the sub-module controller is connected to the power unit. Since each battery management system is connected to the corresponding battery group, the battery management system can receive parameter information of the corresponding battery group, such as voltage, temperature, and SOC of the battery group. Further, since each battery management system is connected to the corresponding battery group and the sub-module controller, the battery management system can send the obtained battery group parameter information to the sub-module controller, and the sub-module controller can determine a control strategy for the power unit in the energy storage module based on the battery group parameter information and control the power unit connected thereto based on the control strategy, thereby controlling the MMC-BESS energy storage valve with the battery group added. In conclusion, the energy storage control system provided in this application is an energy storage control system applicable to MMC-BESS.

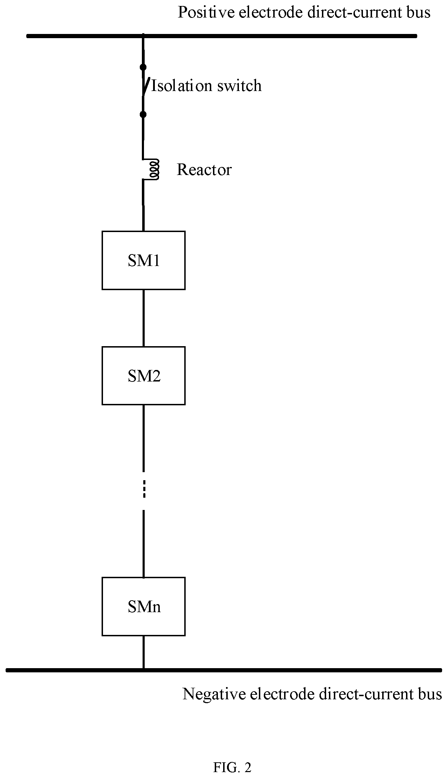

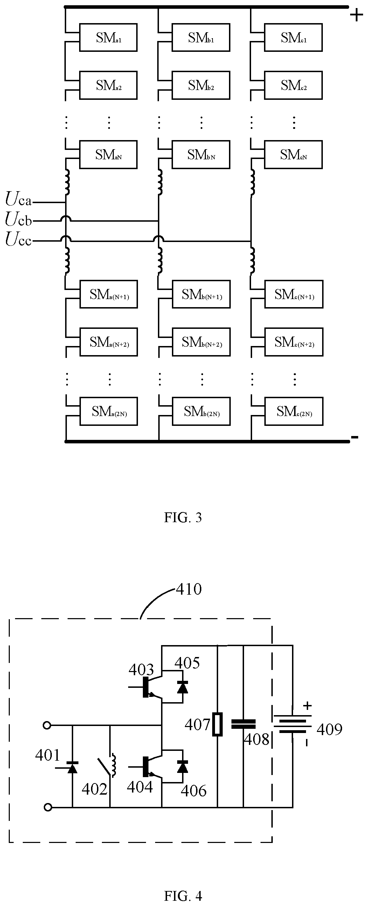

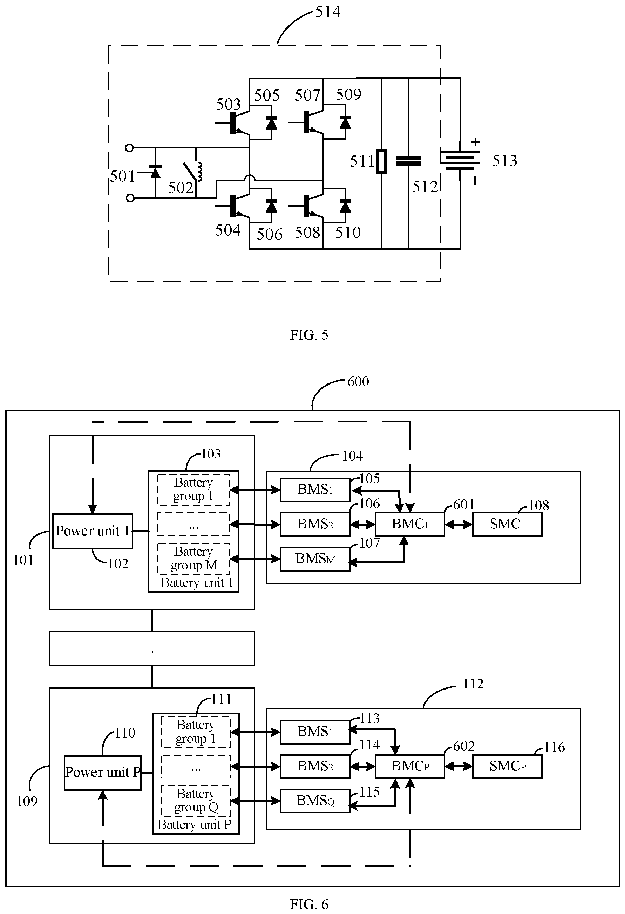

To describe the energy storage control system in this application more clearly, FIGs. 2 and 3 are used to explain the MMC-BESS energy storage valve. FIG. 2 is a schematic structural diagram of a direct-current direct-connected energy storage valve. FIG. 3 is a schematic structural diagram of a VCS energy storage valve. FIG. 4 shows a half-bridge energy storage module. FIG. 5 shows a full-bridge energy storage module.

A direct-current high-voltage direct-connected energy storage valve can be configured on a high-voltage direct-current transmission line, that is, between a positive electrode direct-current bus and a negative electrode direct-current bus. The direct-current high-voltage direct-connected energy storage valve includes an isolation switch, a reactor, at least one energy storage module SMn, and a control system, where n is an integer greater than 1, the total number n of energy storage modules can be configured according to the voltage level of a power transmission system, and SMn represents the nth energy storage module. Similarly, in FIG. 3, in the VCS energy storage valve, three phases of the alternating-current buses Uca, Ucb, and Ucc are all connected in series with cascaded energy storage modules, and the number of cascaded energy storage modules can still be configured according to the voltage level and capacity of the high-voltage direct-connected energy storage valve. N is an integer greater than or equal to 1. Details are not described herein again.

In this application, the direct-current high-voltage direct-connected energy storage valve and the VCS energy storage valve are both referred to as energy storage valves. The energy storage module in FIG. 2 or FIG. 3 includes a power unit and a battery unit. As an example, in FIG. 4, the energy storage module includes a battery unit 409 and a power unit 410, where the power unit 410 includes a thyristor 401, a bypass switch 402, an upper insulated gate bipolar transistor (Insulated Gate Bipolar Transistor, IGBT) 403, a lower IGBT 404, an anti-parallel diode 405, an anti-parallel diode 406, an equalizing resistor 407, and a capacitor 408.

Similarly, in FIG. 5, the energy storage module includes a battery unit 513 and a power unit 514, where the power unit 514 includes a thyristor 501, a bypass switch 502, an upper IGBT 503, a lower IGBT 504, an anti-parallel diode 505, an anti-parallel diode 506, an upper IGBT 507, a lower IGBT 508, an anti-parallel diode 509, an anti-parallel diode 510, an equalizing resistor 511, and a capacitor 512. It should be noted that in addition to the full-bridge and half-bridge structures shown in FIGs. 4 and 5, the power unit may alternatively be in other forms, such as a quasi-full-bridge form. This is not limited in this embodiment. For ease of description, the upper IGBT and the lower IGBT are also referred to as transistors.

FIG. 6 is a schematic structural diagram of another energy storage control system of this application. In this embodiment, as shown in FIG. 6, in some embodiments, based on FIG. 1, the control apparatus further includes a battery management controller (Battery Management Controller, BMC), and the sub-module controller is connected to a plurality of battery management systems through the battery management controller.

As shown in FIG. 6, the energy storage control system 600 further includes a battery management controller 601 and a battery management controller 602. The battery management systems 105 to 107 are connected to the battery management controller 601, and the battery management controller 601 is connected to the sub-module controller 108. The battery management systems 113 to 115 are connected to the battery management controller 602, and the battery management controller 602 is connected to the sub-module controller 116.

In this case, after receiving the battery group parameter information sent by each battery management system, the battery management controller can filter the battery group parameter information sent by each battery management system, remove unnecessary parameter information, and then further send the battery group parameter information to the sub-module controller. This avoids the problem that the sub-module controller needs to establish communication with many battery management systems when there are a large number of battery groups in the battery unit, which otherwise causes large data throughput and high hardware cost for the sub-module controller.

In the embodiments of this application, the control apparatus further includes the battery management controller, and the sub-module controller is connected to the plurality of battery management systems through the battery management controller. This avoids the need for the sub-module controller to directly establish communication with many battery management systems, reducing the data throughput of the sub-module controller and improving control efficiency.

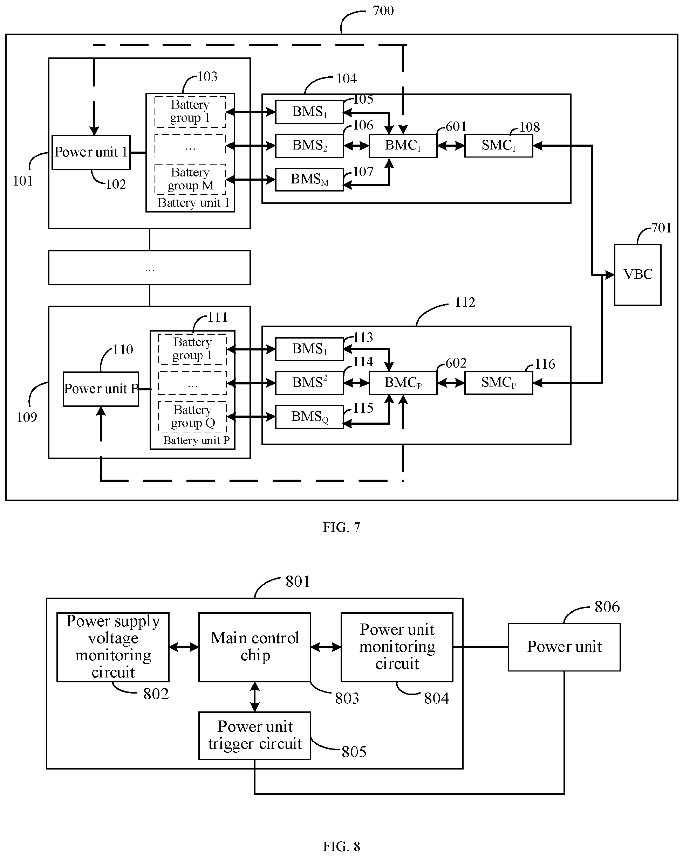

FIG. 7 is a schematic structural diagram of another energy storage control system of this application. In this embodiment, based on FIGs. 1 and 6, in some embodiments, the energy storage control system further includes a valve base controller (Valve Base Controller, VBC).

As shown in FIG. 7, the energy storage control system 700 further includes a valve base controller 701, and the valve base controller 701 is connected to both the sub-module controller 108 and the sub-module controller 116.

In this embodiment, the sub-module controller forwards the obtained battery group parameter information to the valve base controller, or processes the obtained battery group parameter information and then sends the processed battery group parameter information to the valve base controller, and then the valve base controller determines a control strategy based on the battery group parameter information and returns the control strategy to the sub-module controller, so that the sub-module controller controls the power unit of the corresponding energy storage module based on the control strategy, and thus can control the branch switching and branch circulating current suppression of the energy storage valve.

Referring to FIG. 7, for example, the battery management system 105, the battery management system 106, and the battery management system 107 send the battery group parameter information received from the battery groups 1 to M to the battery management controller 601. The battery management controller 601 filters the received battery group parameter information and sends the filtered battery group parameter information to the sub-module controller 108. The sub-module controller 108 forwards the received and filtered battery group parameter information to the valve base controller 701. The valve base controller 701 generates a control strategy and returns the control strategy to the sub-module controller 108, so that the sub-module controller 108 controls the corresponding power unit 102 based on the control strategy.

In this embodiment, the energy storage control system further includes the valve base controller, and the valve base controller is connected to the sub-module controller. Since the sub-module controller can send the battery group parameter information to the valve base controller after receiving the battery group parameter information, and the valve base controller determines the corresponding control strategy, the processing capacity and processing efficiency of the sub-module controller are reduced.

In some embodiments, the sub-module controller includes a main control chip, and the main control chip is connected to a plurality of battery management systems and the valve base controller.

In the embodiments of this application, the main control chip may be a central processing unit (Central Processing Unit, CPU), a digital signal processor (Digital Signal Processing, DSP), a field-programmable gate array (Field-Programmable Gate Array, FPGA), another programmable logic device, or the like.

For example, in this embodiment, the main control chip is a digital integrated circuit (Complex Programmable Logic Device, CPLD) chip or an FPGA chip with an integrated Flash memory, a program storage unit and program execution unit of the main control chip are integrated to avoid loading anomalies caused by independent program storage and execution, improving the reliability of the sub-module controller.

In the embodiments of this application, the energy storage control system further includes the valve base controller, the sub-module controller includes the main control chip, and the main control chip is connected to the plurality of battery management systems and the valve base controller, so the main control chip in the sub-module controller receives the battery group parameter information from the battery management system, sends the processed battery group parameter information to the valve base controller, and receives the control strategy from the valve base controller, thereby improving the functional integration of the sub-module controller.

In some embodiments, the sub-module controller further includes a power unit trigger circuit, and the power unit trigger circuit is connected to both the main control chip and the power unit.

FIG. 8 is a schematic structural diagram of a sub-module controller of this application. As shown in FIG. 8, in this embodiment, a sub-module controller 801 further includes a power unit trigger circuit 805, and the power unit trigger circuit 805 is connected to both a main control chip 803 and a power unit 806. For example, if the power unit trigger circuit 805 is a bypass switch trigger circuit corresponding to a bypass switch in the power unit 806, the sub-module controller 801 can control the bypass switch trigger circuit to trigger the bypass switch in the power unit 806 to be turned on when receiving a control strategy from the valve base controller that indicates that the bypass switch needs to be turned on.

In some embodiments, the main control chip in the sub-module controller can alternatively communicate with a corresponding power unit directly. For example, referring to FIG. 7, after the main control chip in the sub-module controller 108 receives the control strategy sent by the valve base controller 701, if the control strategy indicates that a bypass switch in the power unit 102 needs to be turned on, the main control chip in the sub-module controller 108 can send a turn-on signal to the bypass switch in the power unit 102 so as to control the bypass switch in the power unit 102 to be turned on.

In the embodiments of this application, the sub-module controller further includes the power unit trigger circuit, and the power unit trigger circuit is connected to both the main control chip and the power unit, so that the sub-module controller can control the power unit based on the control strategy after receiving the control strategy sent by the valve base controller.

In some embodiments, the power unit trigger circuit includes at least one of a transistor trigger circuit, a thyristor trigger circuit, and a bypass switch trigger circuit, where the transistor trigger circuit is connected to both the main control chip and a transistor in the power unit, the thyristor trigger circuit is connected to both the main control chip and a thyristor in the power unit, and the bypass switch trigger circuit is connected to both the main control chip and a bypass switch in the power unit.

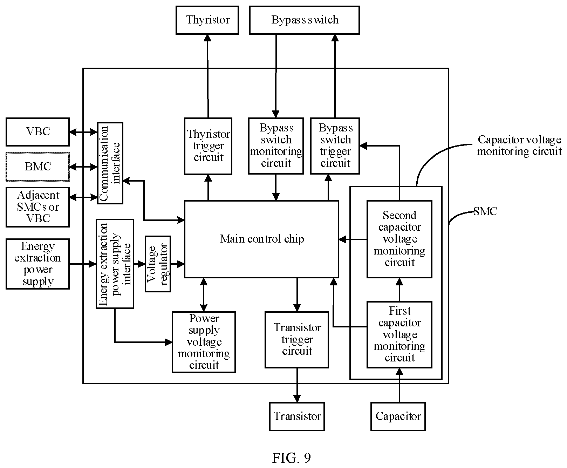

FIG. 9 is a schematic structural diagram of another sub-module controller of this application. In this embodiment, as shown in FIG. 9, the power unit trigger circuit includes at least one of a transistor trigger circuit, a thyristor trigger circuit, and a bypass switch trigger circuit.

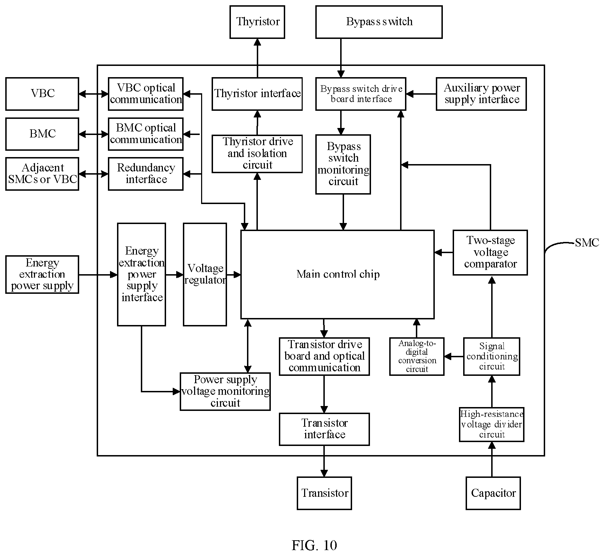

The transistor trigger circuit is connected to both the main control chip and a transistor in the power unit and is used to control the on-off of the transistor in the power unit, for example, to control the on-off of the upper IGBT 403 and the lower IGBT 404 in FIG. 4. For example, FIG. 10 is a schematic structural diagram of another sub-module controller of this application. In this embodiment, the transistor trigger circuit includes a transistor interface and a transistor drive board. The upper IGBT (insulated gate bipolar transistor, Insulate-Gate Bipolar Transistor) and lower IGBT in the power unit are connected to the transistor drive board through the transistor interface, and the transistor drive board is used to control the on-off of the transistor in the power unit.

The thyristor trigger circuit is connected to both the main control chip and a thyristor in the power unit and is used to control the on-off of the thyristor in the power unit, for example, to control the on-off of the thyristor 401 in FIG. 4. For example, referring to FIG. 10, the thyristor trigger circuit includes a thyristor interface and a thyristor drive and isolation circuit. The thyristor in the power unit is connected to the thyristor drive and isolation circuit through the thyristor interface. The thyristor drive and isolation circuit is used to control the on-off of the thyristor in the power unit and perform photoelectric isolation or electromagnetic isolation so as to avoid strong and weak electrical interference.

The bypass switch trigger circuit is connected to both the main control chip and a bypass switch in the power unit and is used to control the on-off of the bypass switch in the power unit, for example, to control the on-off of the bypass switch 402 in FIG. 4. For example, referring to FIG. 10, the bypass switch trigger circuit includes a bypass switch drive board interface. The bypass switch in the power unit is connected to the bypass switch drive board interface. The bypass switch drive board interface is used to control the on or off of the bypass switch in the power unit after receiving an optical signal sent by the main control chip.

In this embodiment, the power unit trigger circuit includes at least one of the transistor trigger circuit, the thyristor trigger circuit, and the bypass switch trigger circuit, where the transistor trigger circuit is connected to both the main control chip and the transistor in the power unit, the thyristor trigger circuit is connected to both the main control chip and the thyristor in the power unit, and the bypass switch trigger circuit is connected to both the main control chip and the bypass switch in the power unit. Therefore, after receiving the control strategy from the valve base controller, the sub-module controller can control different components in the power unit based on different control strategies to control and protect the energy storage valve.

In some embodiments, the sub-module controller further includes a power unit monitoring circuit, and the power unit monitoring circuit is connected to both the main control chip and the power unit.

In the embodiments of this application, still referring to FIG. 8, the sub-module controller 801 further includes a power unit monitoring circuit 804, and the power unit monitoring circuit 804 is connected to both the main control chip 803 and the power unit 806. For example, if the power unit monitoring circuit 804 is a capacitor voltage monitoring circuit corresponding to a capacitor in the power unit 806, the sub-module controller 801 can also monitor voltage information of the capacitor in the power unit 806; further, the sub-module controller 801 can also promptly send the voltage information of the capacitor in the power unit 806 to the sub-module controller 801, so that the sub-module controller 801 can determine a corresponding control strategy based on parameter information of a battery group and the voltage information of the capacitor.

In the embodiments of this application, the sub-module controller further includes the power unit monitoring circuit, and the power unit monitoring circuit is connected to both the main control chip and the power unit. Therefore, the sub-module controller can also monitor the power unit to improve the control accuracy of the energy storage valve.

In some embodiments, the power unit monitoring circuit includes at least one of a capacitor voltage monitoring circuit, a bypass switch monitoring circuit, and a transistor monitoring circuit.

The capacitor voltage monitoring circuit is connected to both the main control chip and a capacitor in the power unit, the bypass switch monitoring circuit is connected to both the main control chip and a bypass switch in the power unit, and the transistor monitoring circuit is connected to both the main control chip and a transistor in the power unit.

In the embodiments of this application, still referring to FIG. 9, the power unit monitoring circuit includes at least one of a capacitor voltage monitoring circuit, a bypass switch monitoring circuit, and a transistor monitoring circuit.

The capacitor voltage monitoring circuit is connected to both the main control chip and a capacitor in the power unit and is used to monitor the voltage of the capacitor in the power unit, for example, to monitor the voltage of the capacitor 408 in FIG. 4. Further, the capacitor voltage monitoring circuit can send the monitored voltage of the capacitor to the main control chip, so that the main control chip can determine whether the bypass switch in the power unit is turned on based on the voltage of the capacitor.

The bypass switch monitoring circuit is connected to both the main control chip and a bypass switch in the power unit and is used to monitor the voltage of the bypass switch in the power unit. Further, the bypass switch monitoring circuit sends the monitored voltage of the bypass switch to the main control chip, so that the main control chip can control a thyristor to start operating through the thyristor trigger circuit when the voltage of the bypass switch in the power unit is abnormal, thereby preventing the bypass switch from failing to operate or misoperating. For example, referring to FIG. 10, the bypass switch monitoring circuit is connected to the bypass switch in the power unit through the bypass switch drive board interface.

The transistor monitoring circuit is connected to both the main control chip and the transistor in the power unit and is used to monitor the voltage of the transistor in the power unit, and the transistor monitoring circuit sends the monitored voltage of the transistor to the main control chip, so that the main control chip controls an action of the transistor based on the monitored voltage of the transistor. For example, referring to FIG. 10, the transistor in the power unit is connected to the main control chip through optical communication, and the transistor in the power unit sends the voltage of the transistor to the main control chip through optical communication.

In the embodiments of this application, the power unit monitoring circuit includes at least one of the capacitor voltage monitoring circuit, the bypass switch monitoring circuit, and the transistor monitoring circuit, where the capacitor voltage monitoring circuit is connected to both the main control chip and the capacitor in the power unit, the bypass switch monitoring circuit is connected to both the main control chip and the bypass switch in the power unit, and the transistor monitoring circuit is connected to both the main control chip and the transistor in the power unit. Therefore, the sub-module controller can also monitor a state of the component in the power unit to more accurately control the energy storage valve based on the state of the component in the power unit.

In some embodiments, the capacitor voltage monitoring circuit includes a first-stage capacitor voltage monitoring circuit, a first-stage capacitor voltage monitoring circuit including a high-resistance voltage divider circuit, a signal conditioning circuit, and an analog-to-digital conversion circuit, where the analog-to-digital conversion circuit is connected to the high-resistance voltage divider circuit through the signal conditioning circuit, the analog-to-digital conversion circuit is connected to the main control chip, and the high-resistance voltage divider circuit is connected to the capacitor in the power unit.

In the embodiments of this application still referring to FIG. 10, the capacitor voltage monitoring circuit includes a first-stage capacitor voltage monitoring circuit, a first-stage capacitor voltage monitoring circuit including a high-resistance voltage divider circuit, a signal conditioning circuit, and an analog-to-digital conversion circuit, where the analog-to-digital conversion circuit is connected to the high-resistance voltage divider circuit through the signal conditioning circuit, the analog-to-digital conversion circuit is connected to the main control chip, and the high-resistance voltage divider circuit is connected to the capacitor in the power unit.

Since the voltage of the capacitor may be large, the high-resistance voltage divider circuit is used for voltage division and current limiting, and the monitored voltage after voltage division and current limiting is subjected to signal conditioning by the signal conditioning circuit, such as an operational amplifier. The voltage of the capacitor is determined and sent to the main control chip after analog-to-digital conversion by the analog-to-digital conversion circuit. Further, the main control chip can make a judgment based on the received voltage of the capacitor. For example, if the voltage of the capacitor exceeds a first preset threshold, an optical signal is triggered to turn on the bypass switch in the power unit so as to avoid anomalies in the power unit due to the excessive voltage of the capacitor.

In the embodiments of this application, the capacitor voltage monitoring circuit includes the first-stage capacitor voltage monitoring circuit, the first-stage capacitor voltage monitoring circuit including the high-resistance voltage divider circuit, the signal conditioning circuit, and the analog-to-digital conversion circuit, where the analog-to-digital conversion circuit is connected to the high-resistance voltage divider circuit through the signal conditioning circuit, the analog-to-digital conversion circuit is connected to the main control chip, and the high-resistance voltage divider circuit is connected to the capacitor in the power unit. Therefore, the sub-module controller can safely and quickly obtain the voltage of the capacitor in the power unit to monitor the voltage of the capacitor in the power unit.

In some embodiments, the capacitor voltage monitoring circuit further includes a second-stage capacitor voltage monitoring circuit, the second-stage capacitor voltage monitoring circuit including a two-stage voltage comparator, where an input terminal of the two-stage voltage comparator is connected to the first-stage capacitor voltage monitoring circuit, and an output terminal of the two-stage voltage comparator is connected to both the main control chip and the bypass switch trigger circuit.

In the embodiments of this application, still referring to FIG. 10, the output of the first capacitor power supply monitoring circuit can be connected to the two-stage voltage comparator in the second-stage capacitor voltage monitoring circuit, that is, the output of the signal conditioning circuit is connected to the input of the two-stage voltage comparator. The output terminal of the two-stage voltage comparator is connected to both the main control chip and the bypass switch trigger circuit. When the voltage of the capacitor output by the signal conditioning circuit is greater than a small second preset threshold, the two-stage voltage comparator sends the voltage of the capacitor to the main control chip for control by the main control chip. When the voltage of the capacitor output by the signal conditioning circuit is greater than a large second preset threshold, the two-stage voltage comparator directly triggers an optical signal to turn on the bypass switch in the power unit so as to avoid anomalies in the power unit due to the excessive voltage of the capacitor.

In the embodiments of this application, the capacitor voltage monitoring circuit further includes the second-stage capacitor voltage monitoring circuit, the second-stage capacitor voltage monitoring circuit including the two-stage voltage comparator, where the input terminal of the two-stage voltage comparator is connected to the first-stage capacitor voltage monitoring circuit, and the output terminal of the two-stage voltage comparator is connected to both the main control chip and the bypass switch trigger circuit. Therefore, the second-stage capacitor voltage monitoring circuit can also directly trigger the bypass switch to be turned on based on the voltage of the capacitor in the power unit, improving the safety of the energy storage valve.

In some embodiments, the sub-module controller can have a built-in power supply apparatus such as a lithium battery or a button battery, and the power supply apparatus of the sub-module controller can be regularly replaced to maintain the operation of the sub-module controller.

In some embodiments, the sub-module controller further includes an energy extraction power supply interface, the energy extraction power supply interface is connected to both a voltage regulator and the main control chip, and the energy extraction power supply interface is connected to an energy extraction power supply.

In this embodiment, referring to FIGs. 9 and 10, the sub-module controller further includes an energy extraction power supply interface, the energy extraction power supply interface is connected to both a voltage regulator and the main control chip, and the energy extraction power supply interface is connected to an energy extraction power supply. The energy extraction power supply is used to supply power to the main control chip, and the voltage regulator may be a low dropout regulator (low dropout regulator, LDO).

In an illustrative embodiment, the sub-module controller may further include an energy extraction capacitor (not shown in the figure), where the energy extraction capacitor is connected to both the voltage regulator and the energy extraction power supply interface. The energy extraction power supply supplies power to the main control chip while charging the energy extraction capacitor, so that when the energy extraction power supply is abnormal, the energy extraction capacitor discharges to support the operation of the sub-module controller for a period of time.

In this embodiment, the sub-module controller further includes the energy extraction power supply interface, the energy extraction power supply interface is connected to both the voltage regulator and the main control chip, and the energy extraction power supply interface is connected to the energy extraction power supply. Due to the use of the energy extraction power supply after voltage regulation for the main control chip, the operating stability of the sub-module controller is improved.

In some embodiments, the sub-module controller further includes a power supply voltage monitoring circuit, and the power supply voltage monitoring circuit is connected to both the energy extraction power supply interface and the main control chip.

In the embodiments of this application, the sub-module controller can monitor voltage information of the energy extraction power supply, and the main control chip of the sub-module controller can report alarm information to the valve base controller when the voltage of the energy extraction power supply approaches a minimum threshold.

In an illustrative embodiment, when the energy extraction power supply is abnormal, for example, when the voltage of the energy extraction power supply is less than the minimum threshold, the energy extraction capacitor discharges to support the operation of the sub-module controller for a period of time, and when the energy extraction power supply is abnormal, the main control chip of the sub-module controller can still report the alarm information to the valve base controller and instruct the bypass switch to be turned on so as to short-circuit the corresponding energy storage module.

In this embodiment, the sub-module controller further includes the energy extraction power supply interface, the energy extraction power supply interface is connected to both the voltage regulator and the main control chip, and the energy extraction power supply interface is connected to the energy extraction power supply. Therefore, the sub-module controller can also monitor the voltage of the energy extraction power supply to avoid the abnormal situation of insufficient power supply of the energy extraction power supply in the sub-module controller, improving the stability of the sub-module controller in use.

In some embodiments, the sub-module controller further includes an auxiliary power supply interface, and the auxiliary power supply interface is connected to the bypass switch trigger circuit.

In this embodiment, referring to FIG. 10, the sub-module controller further includes an auxiliary power supply interface, where the auxiliary power supply interface is connected to the bypass switch trigger circuit, and the auxiliary power supply interface is used to provide redundant power supply to the bypass switch so as to ensure the operating stability of the bypass switch.

In this embodiment, the sub-module controller further includes the auxiliary power supply interface, and the auxiliary power supply interface is connected to the bypass switch trigger circuit. Therefore, the operating stability of the bypass switch is improved.

In some embodiments, the sub-module controller further includes a redundancy interface, and adjacent sub-module controllers in the plurality of control apparatuses or the valve base controller is connected to the main control chip through the redundancy interface.

In this embodiment, referring to FIGs. 9 and 10, the sub-module controller includes a communication interface. The valve base controller, the battery management controller, or the adjacent sub-module controllers can be connected to the sub-module controller through the communication interface. For example, the communication interface includes a valve base controller optical communication interface, a battery management controller optical communication interface, and a redundancy interface.

The valve base controller optical communication interface is connected to both the valve base controller and the main control chip and is used for optical communication between the sub-module controller and the valve base controller. The battery management controller optical communication interface is connected to both the battery management controller and the main control chip and is used for optical communication between the sub-module controller and the battery management controller. The adjacent sub-module controllers in the plurality of control apparatuses or the valve base controller is connected to the main control chip through the redundancy interface, that is, the sub-module controller can implement optical communication with the adjacent sub-module controllers through the redundancy interface. For example, a sub-module controller 1 corresponding to an energy storage module 1 is connected to a sub-module controller 2 corresponding to an energy storage module 2, and the sub-module controller 2 corresponding to the energy storage module 2 is connected to a sub-module controller 3 corresponding to an energy storage module 3. When the sub-module controller corresponding to the energy storage module 1 has an uplink and downlink communication failure with the valve base controller, the sub-module controller corresponding to the energy storage module 1 can communicate with the valve base controller through the sub-module controller 2 corresponding to the energy storage module 2 and report the failure information. The sub-module controller can also implement optical communication with the valve base controller through the redundancy interface. When there is a failure in the optical communication between the sub-module controller corresponding to the energy storage module 1 and the valve base controller, the sub-module controller corresponding to the energy storage module 1 can still communicate with the valve base controller through the redundancy interface.

In this embodiment, the sub-module controller in the control apparatus further includes the redundancy interface, and the adjacent sub-module controllers in the plurality of control apparatuses or the valve base controller is connected to the main control chip through the redundancy interface. Therefore, the stability of the sub-module controller is improved.

In some embodiments, the control apparatus further includes a fire controller, the fire controller is connected to both a fire sensor corresponding to the battery unit and the sub-module controller, and the fire sensor includes at least one of an electrolyte leakage sensor, a temperature sensor, a gas sensor, and a smoke sensor.

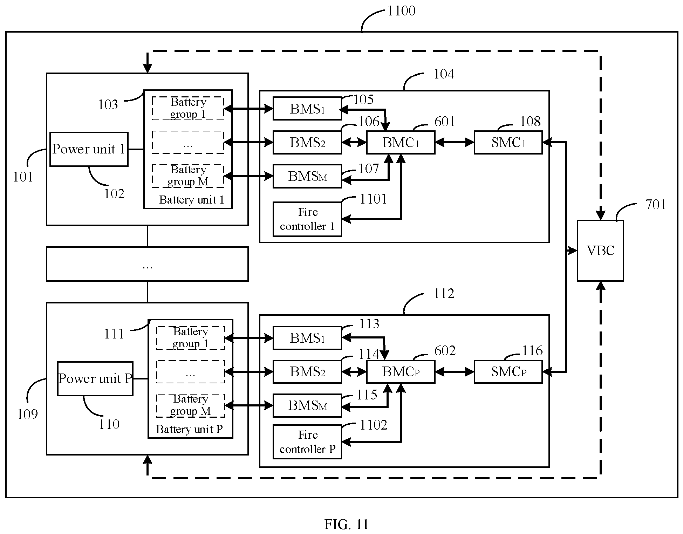

In this embodiment, referring to FIG. 11, FIG. 11 is a schematic diagram of another energy storage control system of this application. The control apparatus further includes a fire controller, the fire controller is connected to both a fire sensor corresponding to the battery unit and the sub-module controller, and the fire sensor includes at least one of an electrolyte leakage sensor, a temperature sensor, a gas sensor, and a smoke sensor.

The fire controller collects fire information from the electrolyte leakage sensor, temperature sensor, gas sensor, and smoke sensor of the battery unit and sends the fire information to the battery management controller, then the battery management controller forwards the fire information to the sub-module controller, and the sub-module controller forwards the fire information to the valve base controller, so that the valve base controller determines a corresponding fire strategy based on the fire information, for example, controlling the fire sensor to perform a fire sprinkling action; and the fire strategy is returned to the fire sensor through the sub-module controller and the battery management controller.

Referring to FIG. 11, in an energy storage control system 1100, the control apparatus 104 further includes a fire controller 1101, and the control apparatus 112 includes a fire controller 1102. For example, the fire controller 1101 sends the fire information to the battery management controller 601, then the battery management controller 601 forwards the fire information to the sub-module controller 108, and the sub-module controller 108 forwards the fire information to the valve base controller 701, so that the valve base controller 701 determines a corresponding fire strategy based on the fire information, and the fire strategy is returned to the fire controller 1108 through the sub-module controller 108 and the battery management controller 601. The same applies to other energy storage modules. Details are not described herein again.

In some embodiments, the fire controller and the battery management controller can alternatively determine the corresponding fire strategy directly based on the fire information.

In this embodiment, the control apparatus further includes the fire controller, the fire controller is connected to both the fire sensor corresponding to the battery unit and the sub-module controller, and the fire sensor includes at least one of the electrolyte leakage sensor, the temperature sensor, the gas sensor, and the smoke sensor. Since a fire linkage function is set based on the battery unit, the safety of the energy storage valve is further improved.

Various modules in the above energy storage control system can be implemented entirely or partially through software, hardware, or a combination thereof. The above modules may be embedded in or independent of a processor in a computer device in a hardware form, or may be stored in a memory in the computer device in a software form, helping the processor to call and execute operations corresponding to the above modules.

It should be noted that user information (including but not limited to user device information, user personal information, and the like) and data (including but not limited to data for analysis, data for storage, data for display, and the like) involved in this application are all information and data authorized by the user or fully authorized by all parties.

Technical features in the foregoing embodiments may be combined in any way. For brevity of description, not all possible combinations of the technical features in the foregoing embodiments are described. However, as long as there is no contradiction among combinations of these technical features, all the combinations should be considered within the scope recorded in this specification.

The foregoing embodiments represent only several implementations of this application, and descriptions thereof are specific and detailed, but should not be construed as any limitations on the scope of this application. It should be noted that persons of ordinary skill in the art can further make several modifications and improvements without departing from the concept of this application, and all these modifications and improvements fall within the protection scope of this application. Therefore, the protection scope of this application should be subject to the appended claims.

## Claims

1. An energy storage control system, wherein the energy storage control system comprises a plurality of energy storage modules and a plurality of control apparatuses in one-to-one correspondence with the plurality of energy storage modules, wherein each control apparatus is connected to the corresponding energy storage module, and the energy storage module comprises a battery unit and a power unit, the battery unit comprising at least one battery group; and
the control apparatus comprises a sub-module controller and at least one battery management system in one-to-one correspondence with the at least one battery group, wherein each battery management system is connected to the corresponding battery group and the sub-module controller, and the sub-module controller is connected to the power unit.

2. The energy storage control system according to claim 1, wherein the control apparatus further comprises a battery management controller, and the sub-module controller is connected to a plurality of battery management systems through the battery management controller.

3. The energy storage control system according to claim 1 or 2, wherein the energy storage control system further comprises a valve base controller, and the valve base controller is connected to the sub-module controller.

4. The energy storage control system according to claim 3, wherein the sub-module controller comprises a main control chip, and the main control chip is connected to a plurality of battery management systems and the valve base controller.

5. The energy storage control system according to claim 4, wherein the sub-module controller further comprises a power unit trigger circuit, and the power unit trigger circuit is connected to both the main control chip and the power unit.

6. The energy storage control system according to claim 5, wherein the power unit trigger circuit comprises at least one of a transistor trigger circuit, a thyristor trigger circuit, and a bypass switch trigger circuit, wherein
the transistor trigger circuit is connected to both the main control chip and a transistor in the power unit, the thyristor trigger circuit is connected to both the main control chip and a thyristor in the power unit, and the bypass switch trigger circuit is connected to both the main control chip and a bypass switch in the power unit.

7. The energy storage control system according to claim 6, wherein the sub-module controller further comprises a power unit monitoring circuit, and the power unit monitoring circuit is connected to both the main control chip and the power unit.

8. The energy storage control system according to claim 7, wherein the power unit monitoring circuit comprises at least one of a capacitor voltage monitoring circuit, a bypass switch monitoring circuit, and a transistor monitoring circuit, wherein
the capacitor voltage monitoring circuit is connected to both the main control chip and a capacitor in the power unit, the bypass switch monitoring circuit is connected to both the main control chip and the bypass switch in the power unit, and the transistor monitoring circuit is connected to both the main control chip and the transistor in the power unit.

9. The energy storage control system according to claim 8, wherein the capacitor voltage monitoring circuit comprises a first-stage capacitor voltage monitoring circuit, the first-stage capacitor voltage monitoring circuit comprising a high-resistance voltage divider circuit, a signal conditioning circuit, and an analog-to-digital conversion circuit, wherein the analog-to-digital conversion circuit is connected to the high-resistance voltage divider circuit through the signal conditioning circuit, the analog-to-digital conversion circuit is connected to the main control chip, and the high-resistance voltage divider circuit is connected to the capacitor in the power unit.

10. The energy storage control system according to claim 9, wherein the capacitor voltage monitoring circuit further comprises a second-stage capacitor voltage monitoring circuit, the second-stage capacitor voltage monitoring circuit comprising a two-stage voltage comparator, wherein an input terminal of the two-stage voltage comparator is connected to the first-stage capacitor voltage monitoring circuit, and an output terminal of the two-stage voltage comparator is connected to both the main control chip and the bypass switch trigger circuit.

11. The energy storage control system according to claim 4, wherein the sub-module controller further comprises an energy extraction power supply interface, the energy extraction power supply interface is connected to both a voltage regulator and the main control chip, and the energy extraction power supply interface is connected to an energy extraction power supply.

12. The energy storage control system according to claim 11, wherein the sub-module controller further comprises a power supply voltage monitoring circuit, and the power supply voltage monitoring circuit is connected to both the energy extraction power supply interface and the main control chip.

13. The energy storage control system according to claim 6, wherein the sub-module controller further comprises an auxiliary power supply interface, and the auxiliary power supply interface is connected to the bypass switch trigger circuit.

14. The energy storage control system according to claim 4, wherein the sub-module controller further comprises a redundancy interface, and adjacent sub-module controllers in the plurality of control apparatuses or the valve base controller is connected to the main control chip through the redundancy interface.

15. The energy storage control system according to claim 2, wherein the control apparatus further comprises a fire controller, the fire controller is connected to both a fire sensor corresponding to the battery unit and the sub-module controller, and the fire sensor comprises at least one of an electrolyte leakage sensor, a temperature sensor, a gas sensor, and a smoke sensor.
